# EUROPEAN PATENT APPLICATION

(11) **EP 4 517 841 A1**
(43) Date of publication of application: **05.03.2025**
(21) Application number: 22964778.9
(22) Date of filing: 09.11.2022
(51) Int. Cl.: H01L 31/18

(54) **DRYER AND BATTERY PROCESSING DEVICE**

(71) Applicant: Contemporary Amperex Technology Co., Limited, Ningde, Fujian 352100 (CN); Contemporary Amperex Technology (Hong Kong) Limited, Hong Kong 999077 (HK)
(72) Inventor: CHEN, Guodong, Ningde, Fujian 352100 (CN); LIU, Zhaohui, Ningde, Fujian 352100 (CN); SU, Shuojian, Ningde, Fujian 352100 (CN); LIN, Weile, Ningde, Fujian 352100 (CN); CHEN, Changsong, Ningde, Fujian 352100 (CN); TU, Bao, Ningde, Fujian 352100 (CN); GUO, Yongsheng, Ningde, Fujian 352100 (CN); LIN, Xiangling, Ningde, Fujian 352100 (CN)
(74) Representative: Jacob, Reuben Ellis
(86) International application number: PCT/CN2022/130973
(87) International publication number: WO 2024/098304

(57) **Abstract**

The present application discloses a dryer and a battery processing device. The dryer is used for drying and crystallizing a material. The dryer comprises a vacuum compartment, a crystallization compartment and a heating apparatus. The vacuum compartment forms a first chamber, and the first chamber is used for vacuum drying the material. The crystallization compartment forms a second chamber. The first chamber and the second chamber each have an input end and an output end, and the output end of the first chamber is communicated with the input end of the second chamber, so that the first chamber is communicated with the second chamber to form a continuous material channel. The heating apparatus is arranged in the crystallization compartment and used for heating and crystallizing the material in the second chamber.

## Description

### Technical Field

The present application relates to the field of processing of traction batteries, and in particular to a dryer and a battery processing apparatus.

### Background Art

During processing of materials, it is often necessary to dry the materials, and the materials are usually directly input into a heating device. Since the materials contain volatile solvents, the requirements for a process window during the drying are stringent, the repeatability and robustness of the process are poor, and products tend to have poor uniformity, which are not conducive to scale production.

### Summary of the Invention

A main objective of the present application is to provide a drying machine, in order to solve the problem of poor product uniformity due to a small process window existing in a conventional drying machine.

To achieve the aforementioned objective, the present application provides a drying machine for drying and crystallizing a material. The drying machine includes:
a vacuum compartment, the vacuum compartment forming a first chamber configured to perform vacuum drying on the material;
a crystallization compartment, the crystallization compartment forming a second chamber; the first chamber and the second chamber each having an input end and an output end, and the output end of the first chamber being in communication with the input end of the second chamber, such that the first chamber is in communication with the second chamber to form a continuous material channel; and
a heating device arranged in the crystallization compartment and configured for heating crystallization of the material in the second chamber.

By providing the first chamber and the second chamber to form a material channel, the material is first subjected to vacuum drying in the first chamber, and a volatile solvent in the material is volatilized out, such that the material is brought into a relatively stable intermediate state. Due to the use of the continuous material channel, external impurities are not involved during vacuum drying and heating crystallization, which is conductive to improving product quality.

In some examples, the drying machine further includes:
a gas extraction device, wherein the gas extraction device has an inlet end, and the inlet end of the gas extraction device is in communication with the first chamber to extract a gas from the first chamber.

When the material is subjected to the vacuum drying in the first chamber, the volatile solvent in the material is volatilized out, and the volatilized solvent is extracted out by the gas extraction device, so that the first chamber is kept in a preset drying state, and an adverse effect of the volatile solvent on the material is avoided.

In some examples, the gas extraction device further has an outlet end, and the outlet end of the gas extraction device is in communication with the second chamber. The volatile solvent in the first chamber is extracted into the second chamber by using the gas extraction device, so that the atmosphere in the second chamber can be controlled, and the crystallization effect is relatively controllable.

In some examples, the gas extraction device further has an outlet end, and the drying machine further includes:
a temporary storage device having an inlet end, the outlet end of the gas extraction device being in communication with the inlet end of the temporary storage device.

By temporarily storing the volatile solvent extracted out of the first chamber in the temporary storage device, the volatile solvent can be collected and reutilized easily, and the utilization rate of raw materials can thus be improved.

In some examples, the temporary storage device further has an outlet end, and the outlet end of the temporary storage device is in communication with the second chamber.

By re-delivering the gas in the temporary storage device to the second chamber, the atmosphere in the second chamber can be adjusted during a heating crystallization process, so that the atmospheres during the drying and crystallization of the material are kept consistent, and thus the product quality is improved.

In some examples, the first chamber and/or the second chamber is a closable chamber. By using the closable chamber, process parameters can be controlled easily, so that the reaction of the material is more controllable.

In some examples, the drying machine further includes:
a first transition compartment, wherein a first transition chamber is formed in the first transition compartment and has an input end and an output end; and
the output end of the first chamber is in communication with the input end of the first transition chamber, the output end of the first transition chamber is in communication with the input end of the second chamber, and the first chamber, the first transition chamber and the second chamber form the material channel.

By providing the first transition compartment, the first transition compartment can cooperate with the vacuum compartment to reduce a gas pressure between the vacuum compartment and the crystallization compartment and facilitate the conveying of the material into the crystallization compartment.

In some examples, the first transition chamber is a closable chamber. By forming the closable chamber, the control and adjustment on the process parameters can be achieved. The first chamber and the second chamber are closed by utilizing the first chamber, so that the process parameters of the first chamber and the second chamber can be controlled easily.

In some examples, the first transition chamber includes a plurality of first transition sub-chambers that are in communication with each other in sequence, the first transition sub-chamber adjacent to the first chamber is in communication with the output end of the first chamber, and the first transition sub-chamber adjacent to the second chamber is in communication with the input end of the second chamber.

By providing the plurality of first transition sub-chambers, the parameters, such as gas pressure and/or temperature, of each first transition sub-chamber can be set according to requirements, so that the first transition compartment can provide a transition effect between the vacuum compartment and the crystallization compartment, the conveying of the material is facilitated while enabling the material to transition between two processes, to improve a material drying effect.

In some examples, the drying machine further includes:
a vacuumizing device, wherein the vacuumizing device has an inlet end, and the inlet end of the vacuumizing device is in communication with the first chamber.

By providing the vacuumizing device on the drying machine, the gas can be easily extracted out of the first chamber according to requirements, to form a required negative pressure state in the first chamber.

In some examples, the inlet end of the vacuumizing device is further in communication with the first transition chamber.

The vacuumizing device is configured to vacuumize the first transition chamber to form a certain degree of negative pressure in the first transition chamber, so that the pressure in the first transition chamber is close to the pressure in the first chamber to facilitate the opening of a sealing member between the first transition compartment and the vacuum compartment.

In some examples, the inlet end of the vacuumizing device is in communication with the first transition sub-chamber adjacent to the first chamber, such that the gas pressure of the first transition sub-chamber adjacent to the first chamber can be close to the gas pressure of the first chamber, and the gas pressure transition from the first chamber to the second chamber is thus achieved.

In some examples, the drying machine further includes:
a second transition compartment, wherein the second transition compartment is formed with a second transition chamber for performing vacuum drying on the material, and the second transition chamber has an input end and an output end; and the output end of the second transition chamber is in communication with the input end of the first chamber, and the second transition chamber, the first chamber, the first transition chamber and the second chamber form the material channel.

By providing the second transition compartment, the transition can be formed at the input end of the first chamber to facilitate the control on the process parameters of the first chamber.

In some examples, the drying machine further includes:
a vacuumizing device, wherein the vacuumizing device has an inlet end, and the inlet end of the vacuumizing device is in communication with the second transition chamber.

By extracting out the gas from the second transition chamber by the vacuumizing device, the second transition chamber serves as a transition chamber between the input end of the first chamber and the outside, and the first chamber can thus be opened easily.

In some examples, the heating device includes:
a first heater arranged in the crystallization compartment and configured for heating crystallization of the material in the second chamber.

By providing the first heater for heating, the material can be quickly heated by utilizing the quick heating characteristic of the first heater, and the quick heating crystallization of the material are thus achieved.

In some examples, the drying machine further includes:
a conveying device arranged at the material channel; wherein the conveying device is formed with a conveying platform for placing the material; and the first heater is an optical heater and has a light-emitting side, and the light-emitting side of the first heater is arranged facing the conveying platform.

By arranging the first heater to face the conveying platform, the heating efficiency can be improved effectively, and the light utilization rate of the first heater can be improved.

In some examples, a plurality of first heaters are provided, and the plurality of first heaters are distributed at intervals.

By providing the plurality of first heaters, the quick temperature rise in the second chamber can be achieved, and the heating efficiency can thus be improved.

In some examples, the heating device further includes:
a second heater arranged in the crystallization compartment, the second heater being a circulating heater and configured to heat the material in the second chamber.

The second heater is used for improving the heating efficiency of the second chamber, so that the material can be quickly heated, and the quick heating crystallization of the material can thus be achieved according to requirements. By means of the second heater arranged in the second chamber, the temperature equalization control in the second chamber can be achieved to improve the heating uniformity.

In some examples, the second heater is made of a light-transmitting material.

By using the second heater of the light-transmitting material, the position of the second heater can be easily determined according to requirements, so that while quickly heating the material, the second heater can be mounted at any position without affecting the normal use of the first heater.

In some examples, the second heater is at least partially arranged between the first heater and the material.

The material is heated by the first heater and the second heater on the same side of the material, so that the material can be subjected to quick heating crystallization.

In some examples, the second heater is located on a side of the material away from the first heater.

The first heater and the second heater perform are used to heat the material from different directions to improve the heating efficiency of the material, so that the material can be subjected to quick heating crystallization.

In some examples, the heating device further includes:
a temperature equalizing device arranged in the crystallization compartment and configured to reflect heat generated by the first heater toward the material.

Light generated by the first heater is reflected to the material by means of the temperature equalizing device, the energy generated by the first heater is thus fully utilized to improve an energy utilization rate, and the heating efficiency of the material is also improved.

In some examples, a plurality of crystallization compartments are provided, and each crystallization compartment is provided with the second chamber; the heating device is provided in each crystallization compartment; and
the plurality of crystallization compartments are connected to each other in sequence.

By providing the plurality of crystallization compartments, the annealing crystallization efficiency of the material can be improved by means of the cooperation of the plurality of crystallization compartments. By respectively adjusting the temperatures of the plurality of crystallization compartments, the temperatures of the plurality of crystallization compartments can cooperate with the annealing crystallization temperature of the material, and the product quality can be effectively improved.

In some examples, the drying machine further includes:
a sealing member arranged along the material drying channel and configured to seal a corresponding position of the material drying channel.

By dividing the drying machine into a plurality of functional chambers and using the sealing members to open or close a corresponding region, a vacuum drying process and a heating crystallization process are respectively performed in the relatively separate chambers, so that the drying machine and the crystallization compartment can each operate separately to improve the material processing efficiency, and the process parameters of the two processes can also be easily controlled respectively.

In some examples, the drying machine is configured to dry and crystallize a perovskite cell material.

On the basis of the examples of the drying machine described above, the present application further provides an example of a battery processing apparatus, the battery processing apparatus including a drying machine as described in any one of the above examples.

By performing the heating and annealing crystallizations on the material after being subjected to the vacuum drying with the drying machine, a longer process window can be provided for the material, the repeatability and robustness of the material processing process can thus be improved, which is conductive to improving the quality of the material, and the quality of traction battery products can then be improved.

### Brief Description of the Drawings

In order to more clearly describe the technical solutions in the embodiments of the present application or in the prior art, the accompanying drawings required for describing the embodiments or the prior art will be briefly described below. Apparently, the accompanying drawings in the following description merely show some of the embodiments of the present application, and those of ordinary skill in the art may still derive other accompanying drawings according to the structures shown by these accompanying drawings without involving creative efforts.
FIG. 1 is a schematic structural diagram of a drying machine according to an example of the present application;
FIG. 2 is a schematic structural diagram of a drying machine according to another example of the present application;
FIG. 3 is a sectional view taken along line 2a-2a in FIG. 1; and
FIG. 4 is a schematic diagram of an internal structure of a drying machine according to another example of the present application.

List of reference signs:

| Reference sign | Name | Reference sign | Name |
|---|---|---|---|
| 10 | Drying machine | 11 | Vacuum compartment |
| 111 | First chamber | 12 | Second transition compartment |
| 121 | Second transition chamber | 13 | First transition compartment |
| 131 | First transition chamber | 131a | First transition sub-chamber |
| 14 | Gas extraction device | 15 | Vacuumizing device |
| 16 | Sealing member | 20 | Crystallization compartment |
| 21 | Second chamber | 22 | Heating device |
| 221 | First heater | 222 | Second heater |
| 223 | Temperature equalizing device | 30 | Conveying device |
| 40 | Feeding table | 50 | Discharging table |
| 60 | Tray | 70 | Valve |
| 80 | Gas pressure valve | 90 | Temporary storage device |

The implementations, functional characteristics and advantages of the objective of the present application will be further described with reference to the accompanying drawings in conjunction with the embodiments.

### Detailed Description of Embodiments

The technical solutions in the embodiments of the present application are clearly and completely described below with reference to the accompanying drawings in the embodiments of the present application. Apparently, the described embodiments are merely some rather than all of the embodiments of the present application. All the other embodiments obtained by those of ordinary skill in the art based on the embodiments of the present application without creative efforts shall fall within the scope of protection of the present application.

It should be noted that, if directional indications (such as up, down, left, right, front, rear...) are involved in the embodiments of the present application, the directional indications are merely intended to explain a relative positional relationship, a movement status, and the like between components in a specific posture (as shown in the figures). If the specific posture changes, the directional indications change accordingly.

In addition, if the terms "first", "second", etc. are described in the embodiments of the present application, the terms "first", "second", etc. are for descriptive purposes only, and cannot be understood as indicating or implying the relative importance or implicitly indicating the number of indicated technical features. Therefore, the features defined with "first" and "second" may explicitly or implicitly include at least one of the features. In addition, the technical solutions of various embodiments may be combined with each other, but only on the basis that the combination can be implemented by those of ordinary skill in the art. When the combination of the technical solutions results in contradiction or cannot be implemented, it should be considered that such a combination of technical solutions does not exist and is not within the scope of protection of the present application.

A perovskite material has the advantages such as high light absorption coefficient, high carrier mobility, large carrier diffusion length and adjustable band gap, so that the material can be used to manufacture a semiconductor material, especially a material for solar cells or other scenarios. At present, methods for manufacturing a perovskite cell mainly include vacuum evaporation, spray coating, printing, spin coating, etc. In these preparation methods, a solution method is typically used for preparing a high-quality perovskite film, and a solar cell having good performance is formed by forming the high-quality perovskite film.

When processing the perovskite material, in order to enable the material to have a better crystal quality and a relatively good grain size, the perovskite material is typically placed in an annealing apparatus, the saturation of a solution is changed by means of an annealing process, and the perovskite is thus crystallized.

Due to that a volatile solvent is dissolved in the solution, in a preparation process for a perovskite material, the volatilization of the volatile solvent and the crystallization of the perovskite are performed synchronously in some cases when the perovskite is placed in an annealing furnace for heating, so that the duration of a process window of a crystallization process is very short, a product has a very small fault tolerance, and finally the quality of a battery product is affected.

To solve the problems of poor process repeatability and robustness caused by a narrow process window in a preparation device in some cases, the present application provides a drying machine 10, which can be used for the crystallization of a perovskite material to solve the problem of poor product uniformity existing in a drying apparatus.

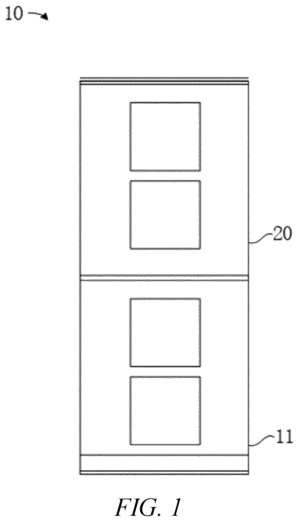

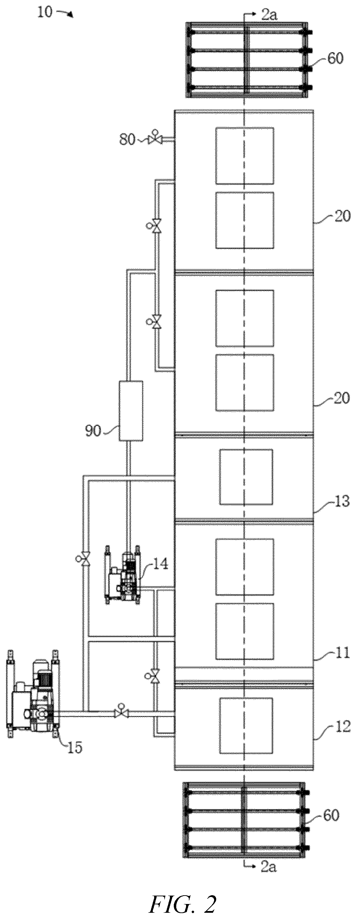

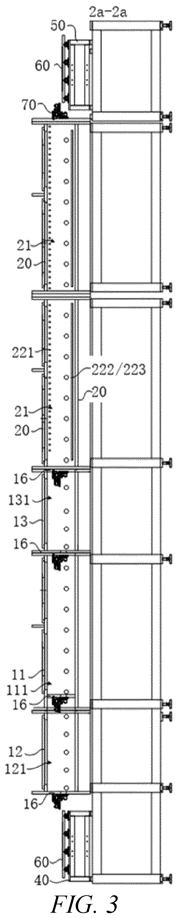

Referring to FIGS. 1, 2 and 3, in some examples, the present application discloses a drying machine 10 for drying and crystallizing a material. The drying machine 10 includes a vacuum compartment 11, a crystallization compartment 20 and a heating device 22. The vacuum compartment 11 forms a first chamber 111, and the first chamber 111 is configured to perform vacuum drying on the material. The crystallization compartment 20 forms a second chamber 21. The first chamber 111 and the second chamber 21 each have an input end and an output end, and the output end of the first chamber 111 is in communication with the input end of the second chamber 21, such that the first chamber 111 is in communication with the second chamber 21 to form a continuous material channel. The heating device 22 is arranged in the crystallization compartment 20 and configured for heating crystallization of the material in the second chamber 21.

The first chamber 111 in the vacuum compartment 11 can form, when needed, a negative pressure device to perform vacuum drying on the material. When the material enters the first chamber 111, the vacuum drying is performed on the material placed in the first chamber 111 by forming a certain degree of negative pressure in the first chamber 111 state. The input end and the output end of the first chamber 111 are each provided on the vacuum compartment 11, such that the material enters the first chamber 111 through the input end of the first chamber 111, and the material is output through the output end of the first chamber 111 after being subjected to the vacuum drying in the first chamber 111.

The crystallization compartment 20 is formed with the second chamber 21, and a heating device 22 is mounted to the crystallization compartment 20 for heating the material in the second chamber 21 to perform heating crystallization on the material. The input end and the output end of the second chamber 21 are each provided on the crystallization compartment 20, and the input end of the second chamber 21 is in communication with the output end of the first chamber 111, such that the material that has been subjected to the vacuum drying in the first chamber 111 can enter the second chamber 21, and the material is output through the output end of the second chamber 21 after being subjected to annealing crystallization in the second chamber 21.

The first chamber **111** and the second chamber 21 forming a continuous material channel means that the material, after being subjected to the vacuum drying process in the first chamber **111,** can be conveyed directly and continuously into the second chamber 21 for annealing crystallization without being subjected to other processes. A material channel for placing the material is formed inside the drying machine 10, and can be opened or closed. When being opened, the material channel can be used for inputting or outputting the material; and when being closed, a separate space is formed in the material channel, such that the material can be isolated from the outside of the drying machine 10.

After the material is put into the first chamber **111,** the first chamber **111** is closed such that the material is isolated from the outside. A gas in the first chamber 111 is extracted by using the vacuumizing device 15, such that a gas pressure in the first chamber 111 is reduced to perform vacuum drying on the material in the first chamber 111. Since a vacuum negative pressure state is formed in the first chamber 111, after the material enters the first chamber 111, a melting point and a boiling point of moisture in the material in the negative pressure state drop as the degree of vacuum increases by means of the vacuum drying performed in the first chamber 111, so that a solution such as water in the material obtains sufficient kinetic energy to escape from a surface of the material.

By forming a negative pressure drying environment, the volatile solvent in the material is volatilized out, so that the material is in an intermediate state. A non-volatile solvent in the material and the material can form a complex, thereby forming the intermediate state in which the material has a stable structure. By keeping the material channel in a closed state, the stable intermediate state can be maintained. By forming the more stable intermediate state, a time window required for annealing in the intermediate state is widened, and no secondary phase is generated during annealing even if the intermediate state is left for a relatively long time, and the quality of a final product is also not affected. Therefore, an annealing window can be extended, and it is thus possible to facilitate the improvement of the fault tolerance of the drying machine 10, improve the production efficiency, and maintain the preset quality of the product. The time window required for annealing in the intermediate state refers to a placement time before being annealed in the intermediate state.

During the annealing, the surface of the annealed material can become rougher in the stable intermediate state. By forming an uneven surface, the rough surface forms a texturized surface, and the effect of light trapping can be provided by performing back light reflection with the texturized surface, so that the material has a higher light absorption efficiency, and it is thus possible to contribute to simplifying a manufacturing process without an additional texturized surface for back reflection.

In this example, the volatile solvent is first extracted out by means of the vacuum drying; and the heating is then performed by the heating device 22 to allow for the annealing crystallization of the material. Since the volatilization of the volatile solvent and the annealing crystallization are both performed separately, the volatilization of the volatile solvent and the annealing crystallization do not interfere with each other, so that the process windows of the volatilization of the volatile solvent and the annealing crystallization can both be widened, and the repeatability of product processing can be improved effectively. Since the two processes do not affect each other, the robustness of the two processes is higher, product defects can be decreased effectively, and thus the product quality can be improved.

In some examples, the first chamber 111 and/or the second chamber 21 is a closable chamber. The first chamber 111 and the second chamber 21 may be in a closed state, and when the vacuum drying and heating crystallization are performed, material channels are all in a closed state, such that the material can be isolated from an external environment, to prevent the material from absorbing gas and impurities in the external environment, thereby avoiding the interaction between the external impurities and the material during the vacuum drying or the annealing crystallization, which otherwise causes the quality of the material to be affected. When the heating device 22 performs heating, the material is placed in the closed second chamber 21, such that the heating device 22 can quickly heat the inside of the second chamber 21, and quick temperature rise of the first chamber 111 is thus easily achieved. When the temperature rises to reach a preset temperature, heat preservation can be easily performed in the first chamber 111 by keeping the first chamber 111 closed, and the material can thus be sufficiently subjected to the annealing crystallization. When the drying machine is used for drying materials of different ingredients, the environment in the first chamber 111 can be easily controlled by utilizing the first chamber 111 in the closed state. The environment includes gas pressure, temperature, humidity, atmosphere, etc., such that the drying machine 10 can be better suitable for drying and crystallizing the different materials, and thus the adaptability of the drying machine 10 can be improved while the quality of the materials is ensured.

The first chamber 111 is a closable chamber. In some examples, a structure such as a gate is provided as a sealing member 16 on the vacuum compartment 11, so that the first chamber 111 serving as a part of the material channel is closed during the vacuum drying. The second chamber 21 is a closable structure. When the heating device 22 heats the inside of the second chamber 21, the second chamber 21 serving as a part of the material channel is kept in the closed state such that the temperature in the second chamber 21 can rise quickly, and the first chamber 111 and the second chamber 21 are provided separately and do not interfere with each other. In some examples, the crystallization compartment 20 is provided with a structure such as a gate as a sealing member 16, so that the second chamber 21 is closed during the heating crystallization. Other structures may also be used as the sealing member 16 described above, which are not limited herein. The first chamber 111 being in communication with the second chamber 21 means that the first chamber 111 is in communication with the second chamber 21 when the sealing member 16 at a joint between the first chamber 111 and the second chamber 21 is opened; and the first chamber 111 and the second chamber 21 are disconnected from each other when the sealing member 16 at the joint between the first chamber 111 and the second chamber 21 is closed.

In this example, the vacuum compartment 11 cooperates with the crystallization compartment 20 to form an overall structure, so that the material that has been subjected to vacuum drying in the vacuum compartment 11 can enter the crystallization compartment 20 more easily, the placement time for the material after being subjected to the vacuum drying can be easily controlled, and it is thus possible to easily control the material to enter the crystallization compartment 20 for annealing crystallization in the annealing process window. The continuity of product processing is higher, the process can be controlled more easily, and the processing quality of the material can thus be controlled effectively.

It can be understood that the vacuum compartment 11 in this example can form a vacuum negative pressure environment in the first chamber 111 to perform a vacuum drying operation on the material. The vacuum compartment 11 may further include other functional components for controlling the vacuum drying process. In this example, the heating device 22 is configured to form a high-temperature environment in the second chamber 21, such that the material is subjected to the annealing crystallization in the second chamber 21, and the heating device 22 can implement the heating and annealing crystallizations of the corresponding material.

In some examples, a vacuumizing device 15 is provided outside the drying machine 10, and the vacuumizing device 15 may serve as a part of the drying machine 10, or the vacuumizing device 15 is detachably connected to the drying machine 10. The vacuumizing device 15 is configured to extract out the gas from the first chamber 111 to maintain a certain negative pressure in the first chamber 111. The vacuumizing device 15 has an inlet end and an outlet end. The inlet end of the vacuumizing device 15 is in communication with the first chamber 111, and the outlet end of the vacuumizing device 15 may be in communication with any space outside the drying machine 10, such that the gas in the first chamber 111 can be extracted out.

The heating device 22 is configured to perform heating crystallization on the material in the second chamber 21. The heating device 22 may be in direct contact with the material to implement contact heating, and the heating device 22 may also heat air in the material channel, so that the heated air heats the material to implement indirect heating.

In some examples, the heating device 22 is mounted at any position in the first chamber 111, and configured to perform heating and annealing crystallizations on the material after the vacuum drying of the material is completed. In some examples, the material is placed in a tray 60, and the heating device 22 may be arranged adjacent to the tray 60, such that the heating device 22 can directly heat the material in the tray 60. In some examples, the heating device 22 and the tray 60 are in contact with each other, and heat is transferred to the material by means of the tray 60, so as to implement the heating and annealing crystallizations of the material.

In some examples, the drying machine 10 has a conveying device 30 for conveying the material, and the material is moved along a trajectory formed by the conveying device 30. The heating device 22 may be suspended at an outer side of the conveying device 30, and the heating device 22 heats the gas around the material to implement indirect heating on the material. Alternatively, the heating device 22 may be directly arranged on the conveying device 30 to directly heat the material.

In some examples, the conveying device 30 may drive the material to be conveyed continuously along the material channel, and the residence time of the material in the first chamber 111 and/or the second chamber 21 is controlled by controlling an operation speed of the conveying device 30. Alternatively, the conveying device 30 may drive the material to be conveyed intermittently along the material channel, such that after the material is resided in the first chamber 111 for a first preset time, and then after a second preset time which is within the process window time of the annealing crystallization process of the material, the material enters the second chamber 21 and is resided in the second chamber 21 for a third preset time to complete the annealing crystallization operation.

In some examples, a gas pressure valve 80 is provided in the crystallization compartment 20, and the gas pressure valve 80 is in communication with the second chamber 21, to control the gas pressure of the crystallization compartment 20 by means of the gas pressure valve 80. In some examples, the output end of the second chamber 21 is provided with a valve 70 for closing the output end of the second chamber 21 to control the temperature of the second chamber 21. When the annealing crystallization on the material in the second chamber 21 is completed, the valve 70 is then opened to take out the material from the second chamber 21.

Continuing to refer to FIG. 1, in some examples, the drying machine 10 further includes a gas extraction device 14. The gas extraction device 14 has an inlet end, and the inlet end of the gas extraction device 14 is in communication with the first chamber 111 to extract a gas from the first chamber 111.

When the vacuum drying process is performed, the volatile solvent in the material is volatilized out, and the volatile solvent is extracted out by the gas extraction device 14, so that the material is brought into the stable intermediate state during the vacuum drying, the process window during the annealing crystallization of the material is widened, facilitating the adjustment of process parameters in the drying machine 10 within the process window, and the controllability and repeatability of the drying process can be improved effectively while the product quality is ensured. Since the volatile solvent is extracted, it can be prevented that the volatile solvent is secondarily bonded with the material within the heating crystallization process window of the material to affect the stability of the intermediate state.

The inlet end of the gas extraction device 14 is in communication with the first chamber 111, the gas extraction device 14 may further have an outlet end, and the outlet end of the gas extraction device 14 may be configured to be in communication with the outside of the drying machine 10 or with other containers to recover the volatile solvent.

The vacuum compartment 11 is provided with a through hole in communication with the first chamber 111, the gas extraction device 14 has the inlet end and the outlet end, and the inlet end of the gas extraction device 14 is in communication with the through hole of the vacuum compartment 11 by means of a pipeline, so that the solvent volatilized in the first chamber 111 can be extracted out when the gas extraction device 14 is in operation. In this example, a plurality of through holes in communication with the first chamber 111 are provided in the vacuum compartment 11, and the inlet end of the gas extraction device 14 is in communication with the plurality of through holes respectively to extract the volatilized solvent from different positions. Further, the plurality of through holes are arranged at intervals in the extending direction of the material channel to fully extract out the volatile solvent from the first chamber 111.

Since the volatile solvent in the first chamber 111 can be extracted out, the material in the first chamber 111 can be in the stable intermediate state, the negative pressure environment in the first chamber 111 contributes to improving the stability of the intermediate state, the process window is thus relatively extended before the material enters the crystallization compartment 20, and the parameters of the annealing process can then be adjusted according to requirements, so that the controllability and the repeatability of the annealing crystallization process are higher, the produced product is also more stable, and the product quality can also be improved effectively.

Further, in some examples, the outlet end of the gas extraction device 14 is in communication with the second chamber 21. The volatilized solvent in the first chamber 111 is extracted into the second chamber 21 as a replenishment for the second chamber 21, the volatilized solvent in the second chamber 21 can replenish the material subjected to the annealing crystallization process, so that the crystallization quality of the material can be guaranteed effectively, and the recycling of the volatile solvent can be achieved.

Further, in some examples, the drying machine 10 further includes a temporary storage device 90. The temporary storage device 90 has an inlet end, and the outlet end of the gas extraction device 14 is in communication with the inlet end of the temporary storage device 90. The temporary storage device 90 is configured to store the volatile solvent extracted from the first chamber 111 to prevent air pollution. When needed, the volatile solvent in the temporary storage device 90 may be reutilized.

The temporary storage device 90 may be a gas tank or other closable containers. The inlet end of the temporary storage device 90 may be a hole formed in the temporary storage device 90, or may be a pipeline connected to the temporary storage device 90. The temporary storage device 90 has a chamber for accommodating the volatile solvent, and the volatile solvent enters the temporary storage device 90 through the inlet end thereof for storage.

Further, in some examples, the temporary storage device 90 further has an outlet end, and the outlet end of the temporary storage device 90 is in communication with the second chamber 21. When the vacuum drying process is performed, the gas extraction device 14 extracts the volatile solvent volatilized from the first chamber 111, and the volatile solvent is temporarily stored in the temporary storage device 90. When the annealing crystallization process is performed, the volatile solvent in the temporary storage device 90 can be replenished into the second chamber 21 again, such that a preset atmosphere can be maintained in the second chamber 21, and atmosphere control during the drying of the material is achieved, making the quality of the material more controllable. In some examples, the crystallization compartment 20 is provided with a through hole in communication with the second chamber 21, and the outlet end of the temporary storage device 90 is in communication with the through hole of the crystallization compartment 20, such that the volatile solvent extracted out from the first chamber 111 can enter the second chamber 21. Further, the crystallization compartment 20 is provided with a plurality of through holes, and the plurality of through holes are arranged at intervals in the extending direction of the material channel to uniformly deliver the volatile solvent to the material in the second chamber 21.

In some examples, the drying machine 10 further includes a first transition compartment 13, a first transition chamber 131 is formed in the first transition compartment 13, and the first transition chamber 131 has an input end and an output end. The output end of the first chamber 111 is in communication with the input end of the first transition chamber 131, the output end of the first transition chamber 131 is in communication with the input end of the second chamber 21, and the first chamber 111, the first transition chamber 131 and the second chamber 21 form the material channel.

The first transition compartment 13 is provided with the first transition chamber 131, and the first transition chamber 131 serves as an intermediate transition zone between the first chamber 111 and the second chamber 21. The first transition chamber 131 has an input end and an output end. The input end of the first transition chamber 131 is in communication with the output end of the first chamber 111, and the output end of the first transition chamber 131 is in communication with the second chamber 21, such that the second transition chamber 121, the first chamber 111 and the second chamber 21 form a continuous material channel.

In some examples, the first transition chamber 131 is a closable chamber. The input end of the first chamber or the input end of the second chamber is closed by means of the first transition chamber 131. In some examples, a sealing member 16 is provided at the input end of the first transition chamber 131, such that the sealing member 16 of the first transition chamber 131 can have a sealing effect on the corresponding position of the material channel, and thus the first chamber 111 can be kept in a better vacuum state. Further, optionally, a sealing member 16 is provided at the output end of the first transition chamber 131 such that the first transition chamber 131 and the first chamber 111 are both kept in a preset sealed state.

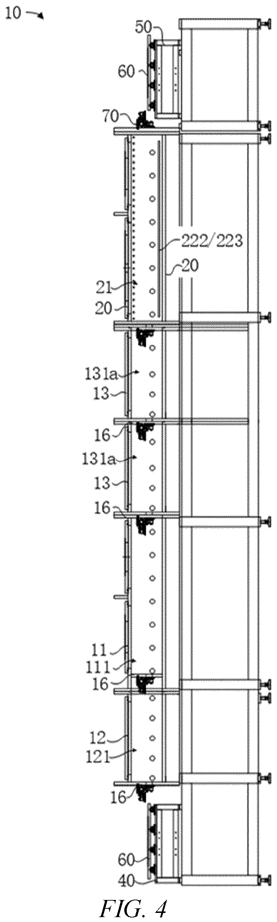

Referring to FIG. 4, in some examples, the first transition chamber 131 includes a plurality of first transition sub-chambers 131a connected to each other in sequence, the first transition sub-chamber 131a adjacent to the first chamber 111 is in communication with the output end of the first chamber 111, and the first transition sub-chamber 131a adjacent to the second chamber 21 is in communication with the input end of the second chamber 21. By forming the plurality of first transition sub-chambers 131a, transition between the first chamber 111 and the second chamber 21 can be implemented easily. This transition involves gas pressure and/or temperature. Since the process window of the material in front of the second chamber 21 is extended, the residence time of the material between the plurality of first transition sub-chambers 131a is extended, the process parameters can thus be controlled and adjusted easily, and the movement and transition of the material between the first chamber 111 and the second chamber 21 can be implemented easily.

In some examples, the plurality of first transition sub-chambers 131a are a plurality of successive independent sub-chambers provided in the first transition chamber 131. In some examples, the plurality of first transition sub-chambers 131a form a plurality of intermediate transition zones between the first chamber 111 and the second chamber 21. In a direction from the vacuum compartment 11 to the crystallization compartment 20, the gas pressure of the plurality of first transition sub-chambers 131a may gradually decrease to achieve a gradual transition of the gas pressure so as to facilitate opening of the sealing member 16. In the direction from the vacuum compartment 11 to the crystallization compartment 20, the temperature of the plurality of first transition sub-chambers 131a may rise gradually to gradually heat the material.

In some examples, the drying machine 10 further includes a vacuumizing device 15. The vacuumizing device 15 has an inlet end, and the inlet end of the vacuumizing device 15 is in communication with the first chamber 111. The first transition chamber 131 is configured to perform vacuum drying on the material. The material enters the first chamber 111 for the vacuum drying; and the material is then conveyed to the first transition chamber 131 for secondary vacuum drying, such that the volatile solvent in the material is fully volatilized, then when the material enters the crystallization compartment 20, the non-volatile solvent in the material and the material are brought into the stable intermediate state, and the product quality can thus be improved. Since the first transition chamber 131 can serve as the transition chamber at the output end of the first chamber 111, the material can be gradually subjected to the vacuum drying, and the volatile solvent in the material can then be fully volatilized to avoid affecting the annealing crystallization process.

The gas pressure in the first transition chamber 131 may be greater than the gas pressure in the first chamber 111, such that the first transition chamber 131 serves as a transition region between the first chamber 111 and the second chamber 21 to avoid the phenomenon that the sealing member 16 cannot be opened normally due to the too large pressure difference between the first chamber 111 and the second chamber 21.

In some examples, a plurality of first transition sub-chambers 131a are provided, and heating devices 22 are provided in the first transition sub-chambers 131a. The first transition sub-chambers 131a are configured for preliminary heating of the material. Further, the drying machine 10 includes a plurality of first transition compartments 13 as described in any one of the above examples. The temperature in the first transition sub-chambers 131a increases gradually in the direction from the vacuum compartment 11 to the crystallization compartment 20.

In some examples, a plurality of first transition sub-chambers 131a are provided, and the inlet end of the vacuumizing device 15 is further in communication with the first transition sub-chambers 131a; and the gas in the corresponding first transition sub-chambers 131a in communication with the vacuumizing device 15 is extracted out by the vacuumizing device, to reduce the gas pressure in the first transition sub-chambers 131a. In some examples, the inlet end of the vacuumizing device 15 is in communication with the first transition sub-chamber adjacent to the first chamber 111.

In some examples, the gas pressure of the first transition sub-chamber 131a adjacent to the vacuum compartment 11 is lower than that of the first transition sub-chamber 131a adjacent to the crystallization compartment 20. Further, in some examples, the gas pressure of the plurality of first transition sub-chambers 131a gradually increases in the direction from the vacuum compartment 11 to the crystallization compartment 20. By means of the gradually increasing gas pressure, the gas pressure between the vacuum compartment 11 and the crystallization compartment 20 is gradually adjusted, the sealing member 16 between adjacent chambers can then be opened easily, and continuous conveying of the material along the material channel can be controlled easily.

In some examples, the vacuumizing device 15 is a vacuum pump. In some examples, a one-way valve is provided at the inlet end of the vacuumizing device 15. By controlling the opening degree of the one-way valve, a flow rate at the corresponding inlet end is controlled, and the gas pressure control of different chambers can be implemented by using a single vacuum pump to bring the plurality of chambers into different gas pressure states.

In some examples, a plurality of first transition sub-chambers 131a are provided, and the inlet end of the gas extraction device 14 is further in communication with the first transition sub-chambers 131a. The gas extraction device 14 is configured to extract out the gas from the first transition sub-chamber 131a connected thereto, such that the volatilized solvent is extracted to the outside of the corresponding chamber.

In some examples, the drying machine 10 further includes a second transition compartment 12. The second transition compartment 12 is formed with a second transition chamber 121 for performing vacuum drying on the material, and the second transition chamber 121 has an input end and an output end. The output end of the second transition chamber 121 is in communication with the input end of the first chamber 111, and the second transition chamber 121, the first chamber 111, the first transition chamber 131 and the second chamber 21 form the material channel.

The first chamber 111 described in any one of the above examples is formed in the vacuum compartment 11 for performing vacuum drying on the material. The vacuum compartment 11 has an input end and an output end which are in communication with the first chamber 111, and the output end of the first chamber 111 is in communication with the input end of the second chamber 21 in any one of the above examples, such that the material that has been subjected to vacuum drying can be conveyed to the second chamber 21.

The second transition compartment 12 is arranged at the input end of the first chamber 111, and the second transition compartment 12 has an input end and an output end. The input end of the second transition compartment 12 serves as a material input position of the drying machine 10, and the output end of the second transition compartment 12 is in communication with the input end of the first chamber 111, such that the material is subjected to vacuum drying in the second transition compartment 12 and then enters the first chamber 111 for secondary vacuum drying.

In some examples, a sealing member 16 is provided at the input end of the second transition chamber 121, such that a better vacuum state can be kept in the material channel to facilitate the vacuum drying of the material. Further, in this example, optionally, sealing members 16 are respectively provided at the input end and the output end of the second transition chamber 121, such that the second transition chamber 121 and the first chamber 111 are both kept in a preset sealed state to facilitate the vacuum drying in the second transition chamber 121.

The second transition chamber 121, the first chamber 111, the first transition chamber 131 and the second chamber 21 form the aforementioned material channel, such that the material is subjected to pre-vacuum drying in the second transition chamber 121, enters the first chamber 111 and is then subjected to the vacuum drying again, thereby contributing to improving the efficiency of vacuum drying. By performing the pre-vacuum drying on the material in the second transition chamber 121, the volatile solvent in the material is partially volatilized, and the secondary vacuum drying is performed in the first chamber 111 after the material enters the first chamber 111, so that the volatile solvent in the material is further reduced, whereas the non-volatile solvent and the material are brought into the stable intermediate state, the defects of the material such as holes caused by the simultaneous performing of the solvent volatilization and the material crystallization after the material enters an annealing furnace, and the product quality can thus be improved.

The gas pressure in the second transition chamber 121 may be equal to the gas pressure in the first chamber 111. Alternatively, the gas pressure in the second transition chamber 121 may be less than the gas pressure in the first chamber 111. The second transition compartment 12 can form a chamber for transition at the input end of the vacuum compartment 11 to avoid the problem that the sealing member 16 of the first chamber 111 cannot be opened due to the too large pressure difference between the first chamber 111 and the outside.

In some examples, a plurality of second transition compartments 12 are provided, and each second transition compartment 12 is formed with a second transition chamber 121. The plurality of second transition compartments 12 are connected to each other in sequence to form a plurality of transition chambers at the input end of the first chamber 111. In a direction from the second transition chambers 121 to the first chamber 111, that is, in a material conveying direction, the gas pressure of the second transition chambers 121 formed by the plurality of second transition compartments 12 increases gradually, such that the gas pressure of the second transition chamber 121 adjacent to the first chamber 111 is close to the gas pressure of the first chamber 111, and the sealing member 16 of the first chamber 111 can be opened easily.

The drying machine 10 is provided with the gas extraction device 14 described in any one of the above examples, and the inlet end of the gas extraction device 14 is in communication with the second transition chamber 121 to extract the volatile solvent from the second transition chamber 121.

In this example, the second transition compartment 12 may be provided with a through hole for connection with the inlet end of the gas extraction device 14, such that the gas extraction device 14 can be in communication with the second transition chamber 121 by means of a pipeline. The second transition compartment 12 may be provided with a plurality of through holes, such that the inlet end of the gas extraction device 14 can be in communication with the second transition chamber 121 at a plurality of positions. Further, the plurality of through holes are arranged at intervals in the second transition compartment 12 in the extending direction of the material channel. The extending direction of the material channel described in this example is consistent with a conveying direction of the material in the drying and crystallization process.

In some examples, the drying machine 10 includes a vacuumizing device 15. The vacuumizing device 15 has an inlet end, and the inlet end of the vacuumizing device 15 is in communication with the second transition chamber 121. The vacuumizing device 15 has the inlet end and an outlet end, and a negative pressure vacuum environment is formed in the drying machine 10 by means of the vacuumizing device 15. Through holes for connection with the vacuumizing device 15 are provided in the drying machine 10 at the positions corresponding to the first chamber 111, the second transition chamber 121 and the first transition chamber 131, such that the inlet end of the vacuumizing device 15 can be in communication with the first chamber 111, the second transition chamber 121 and the first transition chamber 131, respectively. In order to easily control the gas pressure of the second transition chamber 121, the first chamber 111 and the first transition chamber 131, in some examples, throttle valves are respectively provided on pipelines of the vacuumizing device 15 for connection with the second transition chamber 121, the first chamber 111 and the first transition chamber 131 to control flow rates of the corresponding pipelines, so as to implement gas pressure control on the second transition chamber 121, the first chamber 111 and the first transition chamber 131.

In some examples, a plurality of groups of through holes are provided in the drying machine 10 at the position corresponding to each of the second transition chamber 121, the first chamber 111 and the first transition chamber 131, such that the vacuumizing device 15 is correspondingly in communication with the multiple positions of the second transition chamber 121, the first chamber 111, and the first transition chamber 131 to implement rapid pressure reduction of the second transition chamber 121, the first chamber 111 and the first transition chamber 131. The plurality of through holes for connection with the inlet end of the vacuumizing device 15 may be arranged at intervals in the extending direction of the material channel.

In some examples, the drying machine 10 includes the conveying device 30 described in any one of the above examples. In some examples, the drying machine 10 further has a feeding table 40 and a discharging table 50. The feeding table 40 is arranged at the input end of the drying machine 10, the discharging table 50 is arranged at the output end of the crystallization compartment 20, the material may be placed in the tray 60, and the tray 60 is placed on the feeding table 40, such that the material can enter the input end of the drying machine 10 and be conveyed along the material channel by the conveying device 30. After the material is subjected to the annealing crystallization in the second chamber 21 of the crystallization compartment 20, the material is output from the discharging table 50.

In some examples, the drying machine 10 includes the conveying device 30 described in any one of the above examples. The conveying device 30 may continuously convey the material, and the conveying speed of the material and the residence time of the material in the corresponding chamber can be adjusted by controlling a movement speed of the conveying device 30. Alternatively, the conveying device 30 may intermittently convey the material, such that the material is resided in each chamber for a preset time, and the material can be subjected to corresponding process operations in the corresponding chambers.

The heating device 22 is configured to rise the temperature in an annealing chamber to perform the annealing crystallization operation on the material. In some examples, the heating device 22 is a first heater 221, and the first heater 221 is arranged at the crystallization compartment 20 and configured to heat the material in the second chamber 21.

In some examples, the first heater 221 may be an optical heater based on infrared radiation heat transfer. Taking infrared light-based heating as an example, when infrared rays are irradiated onto the material, some of the rays are reflected back while some of the rays penetrate through the material. When the wavelength of the emitted far-infrared rays is consistent with the absorption wavelength of the material, the material absorbs the far-infrared rays, molecules and atoms inside the object resonate in this case, the molecules of the material vibrate and rotate strongly, and the vibration and rotation cause the temperature of the material to rise, thus achieving the purpose of heating. By using the infrared heating device 22, the material can be heated quickly and uniformly, quick temperature rise can thus be achieved, and the efficiency of annealing crystallization can be improved.

Since the material first undergoes the vacuum drying process, the material is brought into the stable intermediate state; when heating and annealing processes are performed, the rough surface forms a texturized surface, and the effect of light trapping can be provided by performing back light reflection with the texturized surface, so that the energy generated by the first heater 221 can be utilized fully to improve the annealing efficiency of the material.

Further, in some examples, the first heater 221 is located above the material, such that the first heater 221 emits infrared rays from top to bottom to act on the surface of the material. This prevents the tray 60, the conveying device 30, etc. from blocking the infrared rays, so that the heating efficiency can be improved.

In some examples, the drying machine 10 further includes a conveying device 30 arranged at the material channel. The conveying device 30 is located in the material channel; the first heater 221 is an optical heater, and the conveying device 30 is formed with a conveying platform for placing the material; and the first heater 221 has a light-emitting side, and the light-emitting side of the first heater 221 is arranged facing the conveying platform.

The conveying platform is configured to place the material, and the material can perform relative motion in the material channel as the conveying device 30 operates. The conveying platform may be a platform parallel to a horizontal plane, such that the material can be conveyed in a horizontal direction. The conveying platform may also be a platform at an included angle with the horizontal plane, such that during conveying of the material in the material channel, a conveying trajectory of the material can change to some extent in an up-down direction, and the material can thus be conveyed as required.

Since the light-emitting side of the first heater 221 faces the conveying platform, the optical radiation generated by the first heater 221 can act directly on the material to avoid blocking the material. When the conveying platform is a platform parallel to the horizontal plane, the first heater 221 is arranged above the conveying platform and emits infrared light to the material in a direction from top to bottom to implement infrared radiation heating. When the conveying platform is arranged at an angle with the horizontal plane, the light-emitting side of the first heater 221 faces the conveying platform, such that the infrared radiation generated by the first heater 221 can act directly on the material on the conveying platform.

Further, in some examples, a plurality of first heaters 221 are provided, and the plurality of first heaters 221 are distributed at intervals. During mounting, the plurality of first heaters 221 may be arranged in the extending direction of the material channel. In some examples, the length direction of the material channel is the extending direction thereof, and the plurality of first heaters 221 are arranged in the width direction of the material channel. By providing the plurality of first heaters 221, the material channel can be quickly heated up easily, and the material channel can be maintained at a preset temperature after temperature rise, so that an annealing temperature in the material channel can be controlled to improve the annealing crystallization efficiency of the material, and by controlling an annealing crystallization temperature, the material can be brought into a more stable and uniform state after the annealing crystallization, to improve the product quality.

In some examples, the first heaters 221 may be distributed in multiple groups, each group includes a plurality of first heaters 221, and the plurality of first heaters 221 in each group are arranged at intervals in the extending direction of the material channel, or the plurality of groups of first heaters 221 may be arranged according to other rules to increase an infrared radiation area.

Further, when the material is conveyed along the conveying platform, the plurality of first heaters 221 may be distributed at intervals in the extending direction of the conveying platform.

In some examples, the heating device 22 further includes a second heater 222. The second heater 222 is arranged at the crystallization compartment 20, and the second heater 222 is a circulating heater and is configured to heat the material in the second chamber 21.

The second heater 222 may be a device having a heating function using electric heating or other heating means. Further, in some examples, the second heater 222 has a channel for accommodating a fluid medium. When the fluid medium flows along the second heater 222, the second heater 222 performs direct or indirect heat exchange with the material and thus heats the material in the material channel. In some examples, the second heater 222 can absorb a part of the heat generated by the first heater 221, and after absorbing and storing a certain amount of heat, the second heater 222 acts on the material in a thermal radiation manner, then fully utilizes the energy of the first heater 221 and can provide the effect of preserving and equalizing the temperature of the material in the second chamber 21.

In some examples, a plurality of second heaters 222 are provided, and the plurality of second heaters 222 are arranged at intervals. The second heaters 222 are configured to heat the material from different parts. By providing the plurality of second heaters 222, the temperature of the material channel can be raised from different positions, such that the material channel can quickly reach the annealing temperature. By means of the cooperation between the plurality of second heaters 222 and the first heater 221, the temperature rise speed of the material channel can further be increased, and a crystallization temperature of the material can be quickly reached in the material channel. By providing the plurality of second heaters 222 to heat the material from different positions, the material is heated more uniformly, and the crystallization quality of the material is thus improved.

In some examples, the second heater 222 is made of a light-transmitting material. The light-transmitting material means that the second heater 222 can allow at least light at some frequencies to pass through. In this example, the second heater 222 can at least allow the infrared light to pass through, such that the second heater 222 does not block the first heater 221. Due to the use of light-transmitting material, the second heater 222 does not affect the first heater 221, and different mounting positions can thus be selected according to requirements, such that the mounting position of the second heater 222 can be closer to the material on the conveying platform, and the heat generated by the second heater 222 can thus be utilized more fully.

Further, in some examples, the second heater 222 is made of a light-transmitting material, and the second heater 222 is arranged between the first heater 221 and the material. The second heater 222 and the first heater 221 can heat the material simultaneously, and the heat can then act quickly on the material to achieve quick temperature rise of the material. When the preset temperature is reached in the material channel, heat preservation can be performed on the material by means of the second heater 222, such that the crystallization temperature of the material can be maintained, and the annealing crystallization of the material is thus implemented.

In some examples, the second heater 222 is located on a side of the material away from the first heater 221, such that the first heater 221 and the second heater 222 heat two sides of the conveying platform respectively, and the second heater 222 also does not block the first heater 221 to fully improve the energy utilization rate of the first heater 221. In some examples, the material is placed on the conveying platform described in any one of the above examples, the quick temperature rise is performed to heat the material by means of the first heater 221 and the second heater 222 arranged on the two sides of the conveying platform, and when the material reaches the annealing crystallization temperature, the heat preservation can be performed on the material by means of the second heater 222 to enable the material to be fully crystallized. Since the two sides of the conveying platform of the material can be exposed to heat, the material is heated more uniformly, which is conductive to improving the product quality.

In some examples, the first heater 221 and the second heater 222 are located on the same side of the conveying platform of the material, and projections of the first heater 221 and the second heater 222 on the horizontal plane are staggered from each other to prevent mutual interference, so that the energy utilization rate can thus be improved.

In order to improve the utilization rate of infrared radiation of the first heater 221, in some examples, the heating device 22 further includes a temperature equalizing device 223. The temperature equalizing device 223 is arranged in the crystallization compartment 20 and configured to reflect the heat generated by the first heater 221 toward the material. The temperature equalizing device 223 may be a reflector, and the temperature equalizing device 223 has a reflective surface. The infrared radiation generated by the first heater 221 diffuses toward an inner wall surface of the second chamber 21, and the temperature equalizing device 223 is configured to reflect the infrared radiation toward the material to improve the energy utilization rate. Since the infrared radiation generated by the first heater 221 can more concentratively act on the material, the heating speed of the material can be effectively increased. In this example, the temperature equalizing device 223 has the reflective surface capable of reflecting the infrared radiation, where the reflective surface may be a flat surface, a cambered surface, or a combination of a flat surface and a cambered surface.

Further, in this example, the second heater 222 is further provided in the second chamber 21, the temperature equalizing device 223 and the second heater 222 are both arranged on the inner wall surface of the second chamber 21, and the temperature equalizing device 223 and the second heater 222 are staggered from each other, so that the second heater 222 can be used to quickly heat the material, the temperature equalizing device 223 can be used to reflect the infrared radiation generated by the first heater 221 toward the material, and the uniform temperature in the material channel is achieved by means of the cooperation of various assemblies.

In some examples, a plurality of crystallization compartments 20 are provided, and each crystallization compartment 20 is formed with the second chamber 21; the heating device 22 is provided in each crystallization compartment 20; and the plurality of crystallization compartments 20 are connected to each other in sequence.

The plurality of crystallization compartments 20 each have the second chamber 21, and the plurality of second chambers 21 can each be used to perform the annealing crystallization on the material. Since the crystallization compartments 20 are used to perform the annealing crystallization on the material that has been subjected to the vacuum drying in the vacuum compartment 11, the plurality of second chambers 21 for annealing crystallization are formed by providing the plurality of crystallization compartments 20 in communication with each other, to improve the annealing efficiency of the material. The heating device 22 is provided in each crystallization compartment 20, such that the plurality of crystallization compartments 20 cooperate with each other to provide a heat preservation effect, the material is at the annealing crystallization temperature and can then be fully crystallized, and the problem of the material being not uniform due to a non-uniform temperature is avoided, thereby contributing to maintaining the product quality.

When the annealing crystallization is performed on different materials, the annealing requirements for different materials can be met by setting the temperatures in the plurality of second chambers 21, and the quality of annealing crystallization of the material can thus be controlled according to requirements.

In some examples, the drying machine 10 has the gas extraction device 14 described in any one of the above examples, the gas extracted by the gas extraction device 14 is delivered into the plurality of second chambers 21, and the amounts of the gas input into the second chambers 21 may be equal or unequal. By inputting the gas extracted by the gas extraction device 14 into the second chambers 21, the atmosphere control in the plurality of second chambers 21 can be controlled easily.

On the basis of any one of the above examples, further, the drying machine 10 further includes a sealing member 16. The sealing member 16 is arranged along the material drying channel and configured to seal a corresponding position of the material drying channel. The sealing member 16 may be a gate or other structures capable of sealing corresponding port parts. In some examples, sealing members 16 are respectively provided at the input end and the output end of each chamber in any one of the above examples. In some examples, a sealing member 16 described above is provided at an input end of a chamber for inputting the material into the drying machine 10 (for example, the input end of the second transition chamber 121 away from the vacuum compartment 11), a sealing member 16 described above is provided at an output end of a chamber for outputting the material to the outside of the drying machine 10 (for example, the output end of the second chamber 21 away from the vacuum compartment 11), and a sealing member 16 described above is provided between chambers arranged adjacent to each other.

Referring to FIGS. 1, 2 and 3, in some examples, the drying machine 10 includes the vacuum compartment 11, the crystallization compartments 20 and the sealing members 16 described in any one of the above examples. The vacuum compartment 11 is formed with the first chamber 111 for performing the vacuum drying on the material, and the inlet end of the vacuumizing device 15 is in communication with the first chamber 111; the crystallization compartment 20 is formed with the second chamber 21, and the heating device 22 is arranged at the second chamber 21; the first chamber 111 and the second chamber 21 each have an input end and an output end, and the output end of the first chamber 111 is in communication with the input end of the second chamber 21, such that the first chamber 111 and the second chamber 21 form the material channel; and sealing members 16 are respectively provided at the vacuum compartment 11, at the crystallization compartment 20, and between the vacuum compartment 11 and the crystallization compartment 20, and the sealing members 16 are used to open or close the material channel corresponding to the first chamber 111 or the second chamber 21.

The vacuum compartment 11 has the first chamber 111, and the sealing member 16 provided at the vacuum compartment 11 is used to close the first chamber 111, such that the first chamber 111 can be in the closed state. The inlet end of the vacuumizing device 15 is in communication with the first chamber 111, such that the vacuumizing device 15 can extract out the gas from the first chamber 111 to form a certain degree of negative pressure in the first chamber 111.

Since the vacuum compartment 11 and the crystallization compartment 20 are both provided with the corresponding sealing members 16, the first chamber 111 and the second chamber 21 can both be kept in the closed state during the corresponding processes, and the first chamber 111 and the second chamber 21 do not interfere with each other, such that the volatile solvent in the material can first be removed by means of the vacuum drying process, and thus the process window is effectively extended when the annealing crystallization process is performed on the material. By utilizing the first chamber 111 and the second chamber 21 provided separately, the two steps can be executed in sequence, or the two chambers can operate simultaneously, so that the processing efficiency of the material can be improved.

Since the first chamber 111 and the second chamber 21 form the material channel, the material can be directly conveyed to the second chamber 21 after being subjected to the vacuum drying in the first chamber 111; and the material is not in contact with the outside space, so that the material is avoided from being in contact with external impurities, and the processing quality of the material is effectively improved.

Sealing members 16 are formed on the vacuum compartment 11, the sealing members 16 are used to open or close the input end and the output end of the first chamber 111 to seal the first chamber 111 when needed, such that the volatile solvent in the material can be volatilized by means of vacuum drying after the material enters the first chamber 111. After the material undergoes the vacuum drying, the sealing member 16 at the output end of the first chamber 111 is opened to allow the material to enter the second chamber 21 along the material channel. In some examples, a sealing member 16 is provided between the vacuum compartment 11 and the crystallization compartment 20 and configured to close the output end of the first chamber 111 and the input end of the second chamber 21, such that the first chamber 111 and the second chamber 21 are relatively separate.

In some examples, the drying machine described in any one of the above examples is configured for drying and crystallizing a perovskite cell material. The perovskite cell material may be used in devices such as a solar cell.

On the basis of the drying machine described above, the present application further provides an example of a battery processing apparatus, the battery processing apparatus including a drying machine described in any one of the above examples.

It should be noted that since the example of the battery processing apparatus in the present application is based on the examples of the drying machine described above, the example of the battery processing apparatus of the present application includes all the technical solutions of all the embodiments of the drying machine described above, and the technical effects achieved thereby are also exactly the same, which will not described in detail herein.

Referring to FIGS. 1 to 4, in an example of the present application, the drying machine 10 includes a material channel. The material channel is configured to perform vacuum drying on the material, and the material channel can further be configured to perform heating and annealing crystallizations on the material after the vacuum drying. The material channel is a closable channel. After the vacuum drying is performed on the material, the volatile solvent in the material is volatilized out, such that the material is brought into a stable intermediate state, the process window of the material during annealing crystallization is extended, the process parameters of annealing crystallization can thus be determined and adjusted according to requirements, the repeatability and robustness of the process can also be higher, and the product quality can also be controlled easily.

The drying machine 10 includes a second transition compartment 12, a vacuum compartment 11, a first transition compartment 13 and at least two crystallization compartments 20 that are connected to each other in sequence. The second transition compartment 12, the vacuum compartment 11 and the first transition compartment 13 form a part of the drying machine 10. A second transition chamber 121 is formed in the second transition compartment 12, a first chamber 111 is formed in the vacuum compartment 11, a first transition chamber 131 is formed in the first transition compartment 13, and a second chamber 21 is formed in each crystallization compartment 20. Sealing members 16 are provided at an input end and an output end of the second transition chamber 121 to seal a material inlet of the drying machine 10 when needed. Sealing members 16 are provided at an input end and/or an output end of the first transition chamber 131 to seal a material outlet of the drying machine 10 when needed. The drying machine 10 further includes a vacuumizing device 15. The vacuumizing device 15 is configured to extract out the gas from the second transition chamber 121, the first chamber 111 and the first transition chamber 131, such that a certain negative pressure is formed in the corresponding chambers. The material on a feeding table 40 is conveyed into the second transition chamber 121 by a conveying device 30, and after preliminary vacuum drying, the material is conveyed to the first chamber 111 and undergoes vacuum drying in the first chamber 111. The material is then conveyed to the first transition chamber 131 such that the vacuum drying is performed on the material again. During the vacuum drying, the volatile solvent in the material is volatilized out, and the non-volatile solvent in the material and the material are brought into a stable intermediate state, so that the stability of the material can be improved, the process window can be extended before the material enters the crystallization compartment 20, the repeatability of material processing can thus be improved, and the robustness of the product can be higher. The material that has been subjected to the vacuum drying enters the second chamber 21 for annealing crystallization. A first heater 221 and a second heater 222 are provided in the second chamber 21 and configured to rise the temperature of the second chamber 21 to allow the material to quickly reach the crystallization temperature. A temperature equalizing device 223 may also be provided in the second chamber 21 and configured to reflect the infrared radiation generated by the first heater 221 toward the material to improve the energy utilization rate. In this example, at least two crystallization compartments 20 are provided, and the crystallization compartments 20 are connected end to end in series, such that the crystallization temperature can be maintained when the material passes through the plurality of second chambers 21 formed by the crystallization compartments 20, the uniformity of products can thus be improved, and the product quality can be higher.

The above are merely optional examples of the present application, and are not intended to limit the patent scope of the present application. All equivalent structural changes made by using the contents of the description and the accompanying drawings of the present application from the inventive concept of the present application, or all direct/indirect applications of the contents in other related technical fields shall fall within the scope of patent protection of the present application.

## Claims

1. A drying machine for drying and crystallizing a material, the drying machine comprising:
a vacuum compartment, the vacuum compartment forming a first chamber configured to perform vacuum drying on the material;
a crystallization compartment, the crystallization compartment forming a second chamber; the first chamber and the second chamber each having an input end and an output end, and the output end of the first chamber being in communication with the input end of the second chamber, such that the first chamber is in communication with the second chamber to form a continuous material channel; and
a heating device arranged in the crystallization compartment and configured for heating crystallization of the material in the second chamber.

2. The drying machine of claim 1, further comprising:
a gas extraction device, wherein the gas extraction device has an inlet end, and the inlet end of the gas extraction device is in communication with the first chamber to extract a gas from the first chamber.

3. The drying machine of claim 2, wherein the gas extraction device further has an outlet end, and the outlet end of the gas extraction device is in communication with the second chamber.

4. The drying machine of claim 2, wherein the gas extraction device further has an outlet end, and the drying machine further comprises:
a temporary storage device having an inlet end, the outlet end of the gas extraction device being in communication with the inlet end of the temporary storage device.

5. The drying machine of claim 4, wherein the temporary storage device further has an outlet end, and the outlet end of the temporary storage device is in communication with the second chamber.

6. The drying machine of any one of claims 1 to 5, wherein the first chamber and/or the second chamber is a closable chamber.

7. The drying machine of any one of claims 2 to 6, further comprising:
a first transition compartment, wherein a first transition chamber is formed in the first transition compartment and has an input end and an output end; and
the output end of the first chamber is in communication with the input end of the first transition chamber, the output end of the first transition chamber is in communication with the input end of the second chamber, and the first chamber, the first transition chamber and the second chamber form the material channel.

8. The drying machine of claim 7, wherein the first transition chamber is a closable chamber.

9. The drying machine of claim 7, wherein the first transition chamber comprises a plurality of first transition sub-chambers that are in communication with each other in sequence, the first transition sub-chamber adjacent to the first chamber is in communication with the output end of the first chamber, and the first transition sub-chamber adjacent to the second chamber is in communication with the input end of the second chamber.

10. The drying machine of claim 9, further comprising:
a vacuumizing device, wherein the vacuumizing device has an inlet end, and the inlet end of the vacuumizing device is in communication with the first chamber.

11. The drying machine of claim 10, wherein the inlet end of the vacuumizing device is further in communication with the first transition chamber.

12. The drying machine of claim 11, wherein the inlet end of the vacuumizing device is in communication with the first transition sub-chamber adjacent to the first chamber.

13. The drying machine of any one of claims 1 to 12, further comprising:
a second transition compartment, wherein the second transition compartment is formed with a second transition chamber for performing vacuum drying on the material, and the second transition chamber has an input end and an output end; and the output end of the second transition chamber is in communication with the input end of the first chamber, and the second transition chamber, the first chamber, the first transition chamber and the second chamber form the material channel.

14. The drying machine of claim 13, further comprising:
a vacuumizing device, wherein the vacuumizing device has an inlet end, and the inlet end of the vacuumizing device is in communication with the second transition chamber.

15. The drying machine of any one of claims 1 to 14, wherein the heating device comprises:
a first heater arranged in the crystallization compartment and configured for heating crystallization of the material in the second chamber.

16. The drying machine of claim 15, further comprising:
a conveying device arranged at the material channel; wherein the conveying device is formed with a conveying platform for placing the material; and the first heater is an optical heater and has a light-emitting side, and the light-emitting side of the first heater is arranged facing the conveying platform.

17. The drying machine of claim 15 or 16, wherein a plurality of first heaters are provided, and the plurality of first heaters are distributed at intervals.

18. The drying machine of any one of claims 115 to 17, wherein the heating device further comprises:
a second heater arranged in the crystallization compartment, the second heater being a circulating heater and configured to heat the material in the second chamber.

19. The drying machine of claim 18, wherein the second heater is made of a light-transmitting material.

20. The drying machine of claim 19, wherein the second heater is at least partially arranged between the first heater and the material.

21. The drying machine of claim 18, wherein the second heater is located on a side of the material away from the first heater.

22. The drying machine of any one of claims 15 to 121, wherein the heating device further comprises:
a temperature equalizing device arranged in the crystallization compartment and configured to reflect heat generated by the first heater toward the material.

23. The drying machine of any one of claims 1 to 22, wherein a plurality of crystallization compartments are provided; and
the plurality of crystallization compartments are connected to each other in sequence.

24. The drying machine of any one of claims 1 to 23, further comprising:
a sealing member arranged along the material drying channel and configured to seal a corresponding position of the material drying channel.

25. The drying machine of any one of claims 1 to 24, wherein the drying machine is configured to dry and crystallize a perovskite cell material.

26. A battery processing apparatus, comprising a drying machine of any one of claims 1 to 25.
